# EUROPÄISCHE PATENTSCHRIFT

(11) **EP 2 797 075 B1**
(45) Veröffentlichungstag und Bekanntmachung des Hinweises auf die Patenterteilung: **12.09.2018**
(21) Anmeldenummer: 14162261.3
(22) Anmeldetag: 28.03.2014
(51) Int. Cl.: G10K 11/178, G10K 15/02, F01N 1/06, H03F 3/217, H03F 1/02

(54) **System zur Beeinflussung von Abgasgeräuschen, Motorgeräuschen und/oder Ansauggeräuschen**
System for influencing exhaust noise, engine noise and/or intake noise
Système permettant d'influencer les bruits d'échappement, les bruits du moteur et/ou les bruits d'admission

(30) Priorität: 26.04.2013 DE 102013104307; 13.05.2013 DE 102013104885
(43) Veröffentlichungstag der Anmeldung: 29.10.2014
(73) Patentinhaber: Eberspächer Exhaust Technology GmbH & Co. KG, 66539 Neunkirchen (DE)
(72) Erfinder: Buganza, Federico, 73730 Esslingen (DE); Serbetci, Selcuk, 73732 Esslingen (DE); Küger, Jan, 73765 Neuhausen (DE)
(74) Vertreter: Diehl & Partner GbR

(56) Entgegenhaltungen:
- DE-A1- 19 949 685
- US-A- 5 834 977
- US-A1- 2004 175 003
- US-A1- 2012 326 783

## Beschreibung

Die Erfindung betrifft ein System zur Beeinflussung von in Abgasanlagen von verbrennungsmotorisch betriebenen Fahrzeugen geführten Schallwellen (Abgasgeräuschen) und/oder zur Beeinflussung von im Motorraum eines Fahrzeugs durch den Motor erzeugten Motorgeräuschen und/oder zur Beeinflussung von in Ansauganlagen von Verbrennungsmotoren geführten Schallwellen (Ansauggeräuschen).

Unabhängig von der Bauform eines Verbrennungsmotors (beispielsweise Hubkolbenmotor, Rotationskolbenmotor oder Freikolbenmotor) werden infolge der hintereinander ablaufenden Arbeitstakte (insbesondere Ansaugen und Verdichten eines Kraftstoff-Luftgemischs, Arbeiten und Ausstoßen des verbrannten Kraftstoff-Luftgemischs) Geräusche erzeugt. Diese durchlaufen zum einen als Körperschall den Verbrennungsmotor und werden außen am Verbrennungsmotor als Luftschall abgestrahlt. Zum anderen durchlaufen die Geräusche als Luftschall zusammen mit dem verbrannten Kraftstoff-Luftgemisch eine mit dem Verbrennungsmotor in Fluidverbindung stehende Abgasanlage.

Diese Geräusche werden häufig als nachteilig empfunden. Zum einen gibt es gesetzliche Vorgaben zum Lärmschutz, die von Herstellern von verbrennungsmotorisch betriebenen Fahrzeugen einzuhalten sind. Diese gesetzlichen Vorgaben geben in der Regel einen im Betrieb des Fahrzeugs maximal zulässigen Schalldruck vor. Zum anderen versuchen Hersteller, den von ihnen erzeugten verbrennungsmotorisch betriebenen Fahrzeugen eine charakteristische Geräuschentwicklung aufzuprägen, welche zum Image des jeweiligen Herstellers passen und die Kunden ansprechen soll. Diese charakteristische Geräuschentwicklung lässt sich bei modernen Motoren mit geringem Hubraumvolumen häufig nicht mehr auf natürlichem Wege sicherstellen.

Die den Verbrennungsmotor als Körperschall durchlaufenden Geräusche lassen sich gut dämmen und stellen daher in der Regel kein Problem hinsichtlich des Lärmschutzes dar. Aufgrund der zunehmenden Verwendung von Verbrennungsmotoren mit kleinen Hubräumen oder gar von Elektromotoren stellt sich jedoch das Problem, dass das Geräusch des Motors für einen Benutzer häufig nicht ansprechend ist und/oder nicht zum Image eines Herstellers des Fahrzeuges passt.

Bei Elektromotoren kommt zudem das Problem hinzu, dass Fußgänger Elektrofahrzeuge aufgrund des fast vollständig fehlenden Motorgeräusches häufig nicht oder zu spät wahrnehmen. Zur Lösung dieses Problems wird vorgeschlagen, im Motorraum eines Fahrzeugs einen Lautsprecher anzuordnen, und so das gewünschte Motorgeräusch einzustellen oder zu erzeugen.

Die eine Abgasanlage des Verbrennungsmotors zusammen mit dem verbrannten Kraftstoff-Luftgemisch als Luftschall durchlaufenden Geräusche werden durch vor der Mündung der Abgasanlage angeordnete Schalldämpfer reduziert, welche ggf. vorhandenen Katalysatoren nachgeschaltet sind. Derartige Schalldämpfer können beispielsweise nach dem Absorptions- und/oder Reflexionsprinzip arbeiten. Beide Arbeitsweisen weisen den Nachteil auf, dass sie ein vergleichsweise großes Volumen beanspruchen und dem verbrannten Kraftstoff-Luftgemisch einen relativ hohen Widerstand entgegen setzen, wodurch der Gesamtwirkungsgrad des Fahrzeuges sinkt und der Kraftstoffverbrauch steigt.

Als Alternative oder zur Ergänzung von Schalldämpfern werden seit einiger Zeit sogenannte Antischall-Systeme entwickelt, die dem vom Verbrennungsmotor erzeugten und in der Abgasanlage geführten Luftschall elektroakustisch erzeugten Anti-Schall überlagern. Derartige Systeme sind beispielsweise aus den Dokumenten US 4,177,874, US 5,229,556, US 5,233,137, US 5,343,533, US 5,336,856, US 5,432,857, US 5,600,106, US 5,619,020, EP 0 373 188, EP 0 674 097, EP 0 755 045, EP 0 916 817, EP 1 055 804, EP 1 627 996, DE 197 51 596, DE 10 2006 042 224, DE 10 2008 018 085 und DE 10 2009 031 848 bekannt.

Derartige Antischall-Systeme verwenden üblicherweise einen sogenannten *Filtered-x Least mean squares* (FxLMS) Algorithmus, der versucht, ein mittels eines Fehlermikrofons gemessenes Fehlersignal durch Ausgabe von Schall über wenigstens einen mit der Abgasanlage in Fluidverbindung stehenden Lautsprecher auf Null (im Falle der Schallauslöschung) oder einen vorgegebenen Schwellwert (im Falle der Schallbeeinflussung) zu regeln. Zum Erzielen einer vollständigen destruktiven Interferenz der Schallwellen des in der Abgasanlage geführten Luftschalls und des vom Lautsprecher erzeugten Anti-Schalls müssen die vom Lautsprecher herrührenden Schallwellen nach Amplitude und Frequenz den in der Abgasanlage geführten Schallwellen entsprechen, relativ zu diesen jedoch eine Phasenverschiebung von 180 Grad aufweisen. Entsprechen sich die in der Abgasanlage geführten Schallwellen des Luftschalls und die vom Lautsprecher erzeugten Schallwellen des Anti-Schalls zwar in der Frequenz, und weisen sie relativ zueinander eine Phasenverschiebung von 180 Grad auf, entsprechen sich die Schallwellen aber nicht in der Amplitude, kommt es nur zu einer Abschwächung der in der Abgasanlage geführten Schallwellen des Luftschalls. Für jedes Frequenzband des im Abgasrohr geführten Luftschalls wird der Anti-Schall mittels des FxLMS-Algorithmus gesondert berechnet, indem eine geeignete Frequenz und Phasenlage von zwei zueinander um 90 Grad verschobenen Sinusschwingungen bestimmt wird, und die erforderlichen Amplituden für diese Sinusschwingungen berechnet werden. Ziel von Antischall-Systemen ist, dass die Schallauslöschung bzw. Schallbeeinflussung zumindest außerhalb, ggf. aber auch innerhalb der Abgasanlage hörbar und messbar ist. Die Bezeichnung Anti-Schall dient in diesem Dokument zur Unterscheidung zu dem in der Abgasanlage geführten Luftschall. Für sich alleine betrachtet handelt es sich bei Anti-Schall um gewöhnlichen Luftschall. Es wird betont, dass das vorliegende Dokument nicht auf die Verwendung eines FxLMS-Algorithmus beschränkt ist.

Auch in den Ansauganlagen von Verbrennungskraftmaschinen treten Schallwellen auf, die als störend empfunden werden können. Diese Schallwellen werden sowohl durch Turbulenzen in der Luftströmung als auch durch den Verbrennungsmotor selber hervorgerufen. Die Ansauganlage, die auch als Ansaugtrakt bezeichnet wird, umfasst alle Verbrennungsluft führenden Bauteile einer Verbrennungskraftmaschine, die sich vor der Brennkammer oder dem Brennraum befinden.

Bei vorbekannten Systemen zur Beeinflussung von Abgasgeräuschen und/oder Ansauggeräuschen und/oder Motorgeräuschen ist es nachteilig, dass die Zuverlässigkeit der Schallauslöschung bzw. Schallbeeinflussung ungenügend ist, und die bestehenden Systeme einen ungenügenden Wirkungsgrad aufweisen.

Aus der deutschen Offenlegungsschrift DE 199 49 685 A1 sind die Merkmale des Oberbegriffs von Anspruch 1 bekannt. Die Verwendung eines Step-up-Konverters für den Betrieb eines Audio-Verstärkers in einem Kraftfahrzeug ist aus dem US-Patent US 5,834,977 bekannt.

Es ist Aufgabe der vorliegenden Erfindung, ein System zur Beeinflussung von Abgasgeräuschen und/oder Ansauggeräuschen und/oder Motorgeräuschen bereitzustellen, welches eine verbesserte Zuverlässigkeit der Schallerzeugung aufweist.

Die vorstehende Aufgabe wird durch die Kombination der Merkmale des unabhängigen Anspruchs gelöst. Bevorzugte Weiterbildungen finden sich in den Unteransprüchen.

Ausführungsformen eines System zur Beeinflussung von Abgasgeräuschen und/oder Ansauggeräuschen und/oder Motorgeräuschen von Fahrzeugen und insbesondere verbrennungsmotorisch betriebenen Fahrzeugen weisen eine Steuerung und insbesondere eine Antischall-Steuerung und wenigstens einen Lautsprecher auf, welcher Lautsprecher zum Empfang von Steuersignalen mit der Steuerung verbunden ist. Diese Verbindung kann beispielsweise elektrisch oder optisch erfolgen.

Dabei ist der wenigstens eine Lautsprecher in Abhängigkeit eines von der Steuerung empfangenen Steuersignals zum Erzeugen eines Schalls und insbesondere Anti-Schalls in einem zugehörigen Schallerzeuger ausgebildet. Der Schallerzeuger schützt den Lautsprecher vor Verschmutzung und/oder Witterungseinflüssen und/oder thermischer Belastung.

Der Schallerzeuger kann ausgebildet sein, in einem Motorraum eines Fahrzeugs angeordnet zu werden. Eine direkte Anordnung des Lautsprechers ohne Schallerzeuger in dem Motorraum oder in der Abgasanlage ist alternativ möglich.

Alternativ oder zusätzlich kann der Schallerzeuger ausgebildet sein, mit der Abgasanlage in fluide Anbindung gebracht zu werden. Somit ist ein Austausch von in einem Inneren des Schallerzeugers und einem Inneren der Abgasanlage befindlichem Fluid (Flüssigkeit oder Gas) möglich. Dabei ist es nicht erforderlich, dass ein Austausch des gesamten im Schallerzeugers befindlichen Fluids mit dem Inneren der Abgasanlage möglich ist. Vielmehr kann das Innere des Schallerzeugers beispielsweise durch eine Membran des Lautsprechers in zwei Teile unterteilt sein. Die indirekte Einbindung des Lautsprechers in die Abgasanlage über einen Schallerzeuger reduziert die mechanische und thermische Belastung des Lautsprechers durch in der Abgasanlage strömendes Abgas.

Alternativ oder zusätzlich kann der Schallerzeuger ausgebildet sein, mit der Ansauganlage in fluide Anbindung gebracht zu werden.

Die Steuerung weist wenigstens einen Mikroprozessor, wenigstens einen Digital/Analog-Umsetzer, wenigstens einen Verstärker und einen Aufwärtsregler auf. Bei dem Verstärker kann es sich insbesondere um einen analogen Verstärker und weiter insbesondere um einen Audio-Verstärker handeln.

Der wenigstens eine Mikroprozessor ist ausgebildet, ein digitales Steuersignal zu erzeugen, welches geeignet ist, Schall im Inneren der Abgasanlage bzw. Ansauganlage zumindest teilweise und bevorzugt vollständig in Betrag und Phase auszulöschen, wenn der wenigstens eine Lautsprecher mit der Abgasanlage bzw. Ansauganlage in Fluidverbindung steht und basierend auf diesem digitalen Steuersignal betrieben wird. Alternativ oder zusätzlich ist der Mikroprozessor ausgebildet, ein digitales Steuersignal zu erzeugen, welches geeignet ist, ein Geräusch und insbesondere ein Motorgeräusch im Inneren eines Motorraumes zu erzeugen, wenn der wenigstens eine Lautsprecher in dem Motorraum angeordnet ist und basierend auf diesem digitalen Steuersignal betrieben wird.

Der wenigstens eine Mikroprozessor kann jeweils ein einzelnes Bauteil sein, oder in eine andere Steuerungseinheit des Fahrzeugs und insbesondere eine Motorsteuerung für den Verbrennungsmotor des Fahrzeugs integriert sein.

Der wenigstens eine Digital/Analog-Umsetzer ist elektrisch mit dem wenigstens einen Mikroprozessor verbunden und ausgebildet, das von dem wenigstens einen Mikroprozessor ausgegebene digitale Steuersignal in ein analoges Steuersignal umzuwandeln. Diese Verbindung kann beispielsweise elektrisch oder optisch erfolgen. Der wenigstens eine Digital/Analog-Umsetzer kann jeweils ein einzelnes Bauteil sein, oder in den wenigstens einen Mikroprozessor integriert sein.

Der wenigstens eine Verstärker ist elektrisch mit dem wenigstens einen Digital/Analog-Umsetzer verbunden und ausgebildet, das von dem wenigstens einen Digital/Analog-Umsetzer ausgegebene analoge Steuersignal so zu verstärken, dass der wenigstens eine Lautsprecher mit dem verstärkten analogen Steuersignal betrieben werden kann. Bei dem Verstärker kann es sich insbesondere um einen Klasse-AB-Verstärker, Vollbrückenverstärker, Klasse-D-Verstärker oder Klasse-G/H-Verstärker handeln. Vollbrückenverstärker und Verstärker der Klassen AB, G/H zeichnen sich durch eine hohe elektromagnetische Verträglichkeit aus, Verstärker der Klasse D durch einen hohen Wirkungsgrad.

Der Aufwärtsregler ist mit einer Fahrzeugbatterie des Fahrzeugs verbindbar und ausgebildet ist, eine von der Fahrzeugbatterie gelieferte Batteriespannung auf einen konstanten Wert heraufzusetzen und als Versorgungsspannung an den wenigstens einen Verstärker auszugeben. Hierfür ist der Aufwärtsregler elektrisch mit dem wenigstens einen Verstärker verbunden. Allgemein wird gemäß der vorliegenden Erfindung unter einem Aufwärtsregler ein auch als Hochsetzsteller, oder englisch Boost-Converter oder Step-Up-Converter bekannter Gleichspannungswandler verstanden, bei welchem der Betrag der Ausgangsspannung stets größer oder gleich dem Betrag der Eingangsspannung ist. Dabei wird unter einem *"konstanten Wert"* der von dem Aufwärtsregler ausgegebenen Spannung eine Spannung verstanden, deren Wert um höchstens 5 % und insbesondere höchstens 3 % des für die Spannung vorgegebenen Wertes schwankt.

Die Verwendung des Hochsetzstellers gewährleistet, dass dem wenigstens einen Verstärker immer eine konstante Versorgungsspannung zur Verfügung gestellt wird, und bewirkt so eine Abkopplung von der üblicherweise im Bereich zwischen 9 V und 16 V schwankenden Spannung der Fahrzeugbatterie. In der Folge kann der wenigstens eine Lautsprecher des Systems zuverlässig mit einem optimalen Steuersignal betrieben werden. Diese erhöhte Zuverlässigkeit auch bei schwankender Spannung der Fahrzeugbatterie ist besonders wichtig, wenn das System verwendet wird, um gesetzliche Vorgaben hinsichtlich des Schallpegels des die Abgasanlage durchlaufenden Luftschalls einzuhalten.

Weiter erlaubt die Verwendung des Hochsetzstellers die Verwendung von Verstärkern, bei denen die Versorgungsspannung höher als die Spannung der Fahrzeugbatterie ist. Derartige Verstärker erlauben eine Anhebung des Spannungsniveaus des verstärkten analogen Steuersignals verglichen mit Verstärkern, die mit der Spannung der Fahrzeugbatterie betrieben werden. In der Folge können Lautsprecher mit höherer Eingangsimpedanz verwendet werden, und sind bei gleicher Leistung aufgrund der höheren Spannung und der niedrigeren Ströme des verstärkten analogen Steuersignals die ohmschen Leitungsverluste auf der Leitung zwischen dem wenigstens einen Verstärker und dem wenigstens einen Lautsprecher geringer. Die niedrigeren Ströme erhöhen auch die elektromagnetische Verträglichkeit. Zudem erlauben derartige Verstärker eine Anhebung des Verhältnisses von Scheitelwert zu Effektivwert des verstärkten analogen Steuersignals und damit des Scheitelfaktors (Crest-Faktor), da Leistungsreserven gebildet werden können.

Der Aufwärtsregler ist ausgebildet, die von der Fahrzeugbatterie gelieferte Batteriespannung von einer zwischen 9 V und 16 V schwankenden Spannung auf 12 V oder 16 V heraufzusetzen, und als Versorgungsspannung an den wenigstens einen Verstärker auszugeben. Dies liegt deutlich über dem Spannungsniveau der Versorgungsspannung von Verstärkern herkömmlicher Systeme und insbesondere herkömmlicher Antischall-Systeme. Durch das höhere Spannungsniveau kann bei gleicher Leistungsanforderung mit höheren Lautsprecherimpedanzen gearbeitet werden, was zu niedrigeren Versorgungsströmen führt. Dadurch verringern sich die Leitungsverluste bzw. es können kleinere Leitungsquerschnitte verwendet werden, was die Systemkosten senkt. Insgesamt wird damit der Wirkungsgrad des Systems erhöht. Zudem steigt die elektromagnetische Verträglichkeit.

Gemäß einer Ausführungsform ist die Steuerung eine Antischall-Steuerung, die mit einer Motorsteuerung eines Motors und insbesondere Verbrennungsmotors des Fahrzeugs verbindbar ist. Weiter ist der wenigstens eine Mikroprozessor der Steuerung ausgebildet, das digitale Steuersignal in Abhängigkeit von Signalen zu erzeugen, welche von der Motorsteuerung empfangen werden. Auf diese Weise können Betriebszustände des Motors bei der Berechnung des digitalen Steuersignals durch den Mikroprozessor berücksichtigt werden.

Gemäß einer Ausführungsform ist das System ein Antischall-System und weist weiter ein Fehlermikrofon auf, welches mit der Steuerung verbunden und an einer bezüglich der Abgasströmung im Bereich der fluiden Anbindung zwischen Schallerzeuger und Abgasanlage gelegenen Stelle der Abgasanlage anordenbar ist. Dabei bedeutet *"im Bereich der fluiden Anbindung zwischen Schallerzeuger und Abgasanlage gelegenen Stelle",* dass die Stelle, an welcher die fluide Anbindung erfolgt und der Schall zumindest teilweise ausgelöscht wird, von dem Fehlermikrofon bezüglich der Abgasströmung stromaufwärts um nicht mehr als das Zehnfache und insbesondere um nicht mehr als das Fünffache und weiter insbesondere um nicht mehr als das Doppelte des maximalen Durchmessers der Abgasanlage an der Stelle, an welcher der Schall durch das Fehlermikrophon gemessen wird, entlang der Abgasströmung beabstandet ist. Das Fehlermikrofon ist ausgebildet, Schall im Inneren der Abgasanlage zu messen und ein entsprechendes Messsignal an die Steuerung auszugeben. Der wenigstens eine Mikroprozessor der Steuerung ist ausgebildet, von dem Fehlermikrofon erhaltene Signale durch Ausgabe des Steuersignals an den wenigstens einen Lautsprecher zumindest teilweise und bevorzugt vollständig in Betrag und Phase auszulöschen. Es wird jedoch betont, dass die vorliegende Erfindung nicht auf Antischall-Systeme beschränkt ist.

Gemäß einer Ausführungsform ist das System ein Antischall-System und weist weiter ein Fehlermikrofon auf, welches mit der Steuerung verbunden und an einer bezüglich der Ansaugströmung im Bereich der fluiden Anbindung zwischen Schallerzeuger und Ansauganlage gelegenen Stelle der Ansauganlage anordenbar ist. Dabei bedeutet *"im Bereich der fluiden Anbindung zwischen Schallerzeuger und Ansauganlage gelegenen Stelle der Ansauganlage",* dass die Stelle, an welcher die fluide Anbindung erfolgt und der Schall zumindest teilweise ausgelöscht wird, von dem Fehlermikrofon bezüglich der Strömung der angesaugten Luft stromabwärts um nicht mehr als das Zehnfache und insbesondere um nicht mehr als das Fünffache und weiter insbesondere um nicht mehr als das Doppelte des maximalen Durchmessers der Ansauganlage an der Stelle, an welcher das Fehlermikrophon angeordnet ist und der Schall gemessen wird, entlang der Strömung der angesaugten Luft beabstandet ist. Das Fehlermikrofon ist ausgebildet, Schall im Inneren der Ansauganlage zu messen und ein entsprechendes Messsignal an die Steuerung auszugeben. Der wenigstens eine Mikroprozessor der Steuerung ist ausgebildet, von dem Fehlermikrofon erhaltene Signale durch Ausgabe des Steuersignals an den wenigstens einen Lautsprecher zumindest teilweise und bevorzugt vollständig in Betrag und Phase auszulöschen. Es wird jedoch betont, dass die vorliegende Erfindung nicht auf Antischall-Systeme beschränkt ist.

Die Begriffe *"stromaufwärts"* und *"stromabwärts"* sind dabei wie folgt zu verstehen: ein erster Abschnitt eines Strömungspfades ist stromaufwärts eines von dem ersten Abschnitt beabstandeten zweiten Abschnitt desselben Strömungspfades angeordnet, wenn ein entlang des Strömungspfades in eine konstante Richtung strömendes Medium zunächst an dem ersten Abschnitt und erst danach an dem zweiten Abschnitt vorbeiströmt. Der zweite Abschnitt ist dann gleichzeitig bezüglich des selben entlang des Strömungspfades in eine konstante Richtung strömenden Mediums stromabwärts des ersten Abschnitts angeordnet.

Gemäß einer Ausführungsform ist der wenigstens eine Digital/Analog-Umsetzer in den wenigstens einen Mikroprozessor und ggf. auch in eine Motorsteuerung des Fahrzeugs integriert. Hierdurch wird die Anzahl der Komponenten gering gehalten.

Gemäß einer Ausführungsform ist zwischen der Fahrzeugbatterie und dem Aufwärtsregler ein Filter und insbesondere ein Spannungsglätter angeordnet. Hierdurch können Störungen reduziert werden.

Gemäß einer Ausführungsform weist der wenigstens eine Lautsprecher eine Eingangsimpedanz von zwischen 2 Ω und 12 Ω und insbesondere von zwischen 3 Ω und 4 Ω auf. Diese Eingangsimpedanz liegt deutlich über der Eingangsimpedanz der Lautsprecher herkömmlicher Systeme und insbesondere herkömmlicher Antischall-Systeme.

Gemäß einer Ausführungsform ist der Verstärker ein Klasse-D-Verstärker und ist zwischen dem wenigstens einen Verstärker und dem wenigstens einen Lautsprecher ein LC-Tiefpass angeordnet. Gemäß einer Ausführungsform ist weiter zwischen dem wenigstens einen Verstärker und dem wenigstens einen Lautsprecher ein Modul zur Erhöhung der elektromagnetischen Verträglichkeit angeordnet.

Ausführungsformen eines Kraftfahrzeugs weisen einen Verbrennungsmotor mit einer Motorsteuerung, eine Ansauganlage und eine Abgasanlage, die mit dem Verbrennungsmotor jeweils in Fluidverbindung stehen, eine Fahrzeugbatterie und das vorstehend beschriebene System auf. Dabei steht der wenigstens eine Schallerzeuger des Systems mit wenigstens einem von der Ansauganlage oder Abgasanlage in fluider Anbindung. Weiter ist die Steuerung des Systems eine Antischall-Steuerung, die mit der Motorsteuerung des Verbrennungsmotors des Fahrzeugs insbesondere elektrisch verbunden ist.

Gemäß einer Ausführungsform weist die Antischall-Steuerung ein Fehlermikrofon auf, welches an einer bezüglich der Strömung der angesaugten Luft im Bereich der fluiden Anbindung zwischen Schallerzeuger und Ansauganlage gelegenen Stelle der Ansauganlage angeordnet und mit der Ansauganlage verbunden ist. Alternativ oder zusätzlich ist das Fehlermikrophon an einer bezüglich der Strömung des Abgases im Bereich der fluiden Anbindung zwischen Schallerzeuger und Abgasströmung im Bereich der fluiden Anbindung zwischen Schallerzeuger und Abgasanlage gelegenen Stelle der Abgasanlage angeordnet und mit der Abgasanlage verbunden ist. Weiter ist die Antischall-Steuerung mit dem Fehlermikrofon insbesondere elektrisch verbunden.

Alternative Ausführungsformen eines Kraftfahrzeugs weisen einen in einem Motorraum angeordneten Antriebsmotor mit einer Motorsteuerung, eine Fahrzeugbatterie und das vorstehend beschriebene System auf. Bei dem Antriebsmotor kann es sich insbesondere um einen Verbrennungsmotor oder Elektromotor handeln. Dabei steht der wenigstens eine Schallerzeuger des Systems mit dem Motorraum in fluider Anbindung oder ist der wenigstens eine Schallerzeuger in dem Motorraum angeordnet. Weiter ist die Steuerung des Systems mit der Motorsteuerung des Antriebsmotor des Fahrzeugs insbesondere elektrisch verbunden.

In diesem Zusammenhang wird darauf verwiesen, dass in dieser Schrift, sofern im Einzelnen nicht explizit anders angegeben, durchgehend und abweichend vom deutschen Sprachgebrauch der Begriff "steuern" gleichbedeutend mit dem Begriff "regeln" verwendet wird. Dies betrifft auch alle grammatikalischen Abwandlungen beider Begriffe. In dieser Schrift kann daher der Begriff "Steuerung" ebenso eine Rückführung einer Regelgröße bzw. deren Messwerts umfassen, wie sich der Begriff "Regelung" auf eine einfache Steuerkette beziehen kann.

Weiter wird darauf hingewiesen, dass die in dieser Beschreibung und den Ansprüchen zur Aufzählung von Merkmalen verwendeten Begriffe "umfassen", "aufweisen", "beinhalten", "enthalten" und "mit", sowie deren grammatikalische Abwandlungen, generell als nichtabschließende Aufzählung von Merkmalen, wie z. B. Verfahrensschritten, Einrichtungen, Bereichen, Größen und dergleichen aufzufassen sind, und in keiner Weise das Vorhandensein anderer oder zusätzlicher Merkmale oder Gruppierungen von anderen oder zusätzlichen Merkmalen ausschließen.

Weitere Merkmale der Erfindung ergeben sich aus der nachfolgenden Beschreibung von Ausführungsbeispielen in Verbindung mit den Ansprüchen sowie den Figuren. In den Figuren werden gleiche bzw. ähnliche Elemente mit gleichen bzw. ähnlichen Bezugszeichen bezeichnet. Es wird darauf hingewiesen, dass die Erfindung nicht auf die Ausführungsformen der beschriebenen Ausführungsbeispiele beschränkt, sondern durch den Umfang der beiliegenden Patentansprüche bestimmt ist. Insbesondere können die einzelnen Merkmale bei erfindungsgemäßen Ausführungsformen in anderer Anzahl und Kombination als bei den untenstehend angeführten Beispielen verwirklicht sein. Bei der nachfolgenden Erläuterung einiger Ausführungsbeispiele der Erfindung wird auf die beiliegenden Figuren Bezug genommen, von denen
- Figur 1: schematisch eine perspektivische Ansicht eines Antischall-Systems für eine Abgasanlage zeigt,
- Figur 2: schematisch ein Blockdiagramm eines Antischall-Systems im Zusammenwirken mit einer Ansauganlage und einer Abgasanlage eines Verbrennungsmotors zeigt, wobei für die Abgasanlage das Antischall-System aus Figur 1 verwendet werden kann,
- Figur 3: schematisch ein Blockdiagramm einer Steuerung eines Systems gemäß einer Ausführungsform der Erfindung zeigt, wie es in dem Antischall-System der Figuren 1 und 2 verwendet werden kann;
- Figur 4: schematisch ein Blockdiagramm einer Steuerung eines Systems gemäß einer alternativen Ausführungsform der Erfindung am Beispiel eines Systems zur Beeinflussung eines Motorgeräuschs in einem Motorraum zeigt; und
- Figur 5: schematisch ein Kraftfahrzeug zeigt, in welches das erfindungsgemäße System integriert ist.

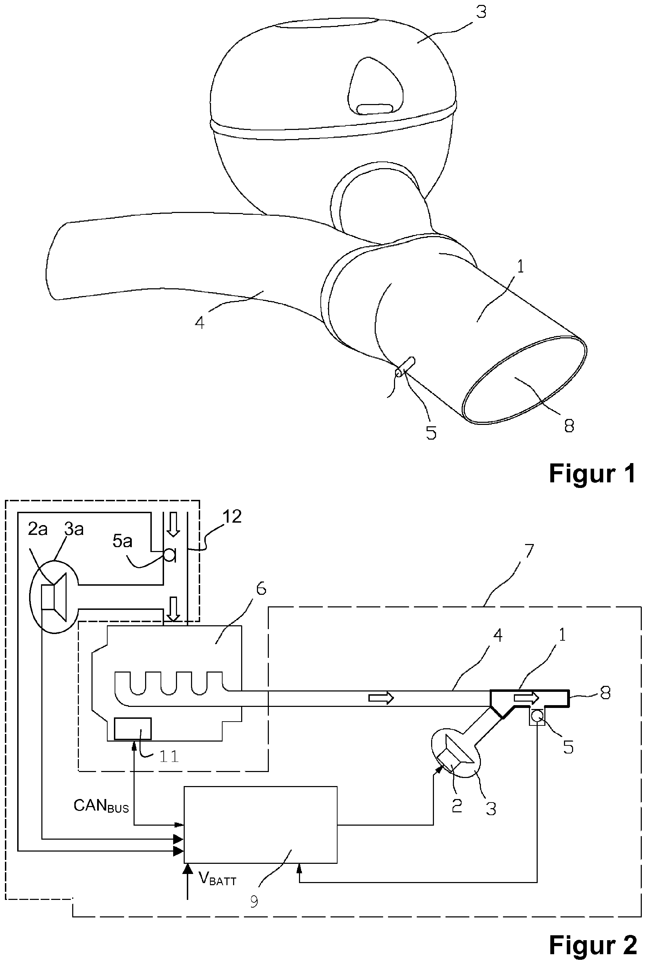

Ein System 7 gemäß einer Ausführungsform der Erfindung wird nachfolgend unter Bezugnahme auf die Figuren 1, 2 und 3 am Beispiel eines Antischall-Systems beschrieben.

Das Antischall-System 7 weist einen Schallerzeuger 3 in Form eines schallisolierten Gehäuses auf, welches einen Lautsprecher 2 enthält und im Bereich eines Endrohrs 1 an eine Abgasanlage 4 angebunden ist.

Das Endrohr 1 weist eine Mündung 8 auf, um in der Abgasanlage 4 geführtes Abgas nach außen abzugeben.

An dem Endrohr 1 ist ein Fehlermikrofon 5 in Form eines Drucksensors vorgesehen. Das Fehlermikrofon 5 misst Druckschwankungen und damit Schall im Inneren des Endrohrs 1 in einem Abschnitt stromabwärts eines Bereichs, in dem die fluide Anbindung zwischen Abgasanlage 4 und Schallerzeuger 3 bereitgestellt wird.

Es wird jedoch betont, dass die vorliegende Erfindung nicht auf eine derartige Anordnung des Fehlermikrofons beschränkt ist. Allgemein ist es ausreichend, wenn das Fehlermikrofon von der fluiden Anbindung zwischen Schallerzeuger und Abgasanlage bezüglich der Abgasströmung stromabwärts um nicht mehr als das Zehnfache und insbesondere um nicht mehr als das Fünffache und weiter insbesondere um nicht mehr als das Doppelte des maximalen Durchmessers der Abgasanlage an dieser fluiden Anbindung entlang der Abgasströmung beabstandet ist. Weiter wird betont, dass das Fehlermikrofon 5 nur optional ist. So ist das Fehlermikrofon nicht erforderlich, wenn Schall im Inneren des Motorraums erzeugt oder beeinflusst werden soll.

Ein dem in Figur 1 gezeigten Schallerzeuger 3 vergleichbarer Schallerzeuger 3a mit einem Lautsprecher 2a ist mit einer Ansauganlage 12 verbunden. Stromaufwärts der angesaugten Luft ist in der Ansauganlage 12 ein Fehlermikrophon 5a angeordnet.

Die Strömungsrichtungen der angesaugten Luft und des Abgases sind in Figur 2 durch Pfeile gekennzeichnet.

Die Lautsprecher 2, 2a und die Fehlermikrofone 5, 5a sind elektrisch mit einer (Antischall-)Steuerung 9 verbunden. Weiter ist die Steuerung 9 über einen CAN-Bus mit einer Motorsteuerung 11 eines Verbrennungsmotors 6 verbunden, und wird von einer Fahrzeugbatterie 10 mit zwischen 9 V und 16 V schwankender Gleichspannung versorgt. Es wird betont, dass anstelle des CAN-Bus auch ein anderer Fahrzeugbus, insbesondere ein LIN-Bus, MOST-Bus oder Flexray-Bus verwendet werden kann.

Die Abgasanlage 4 kann weiter wenigstens einen zwischen dem Verbrennungsmotor 6 und dem Endstück 1 angeordneten Katalysator (nicht gezeigt) zur Reinigung des von dem Verbrennungsmotor 6 emittierten und in der Abgasanlage 4 geführten Abgases aufweisen.

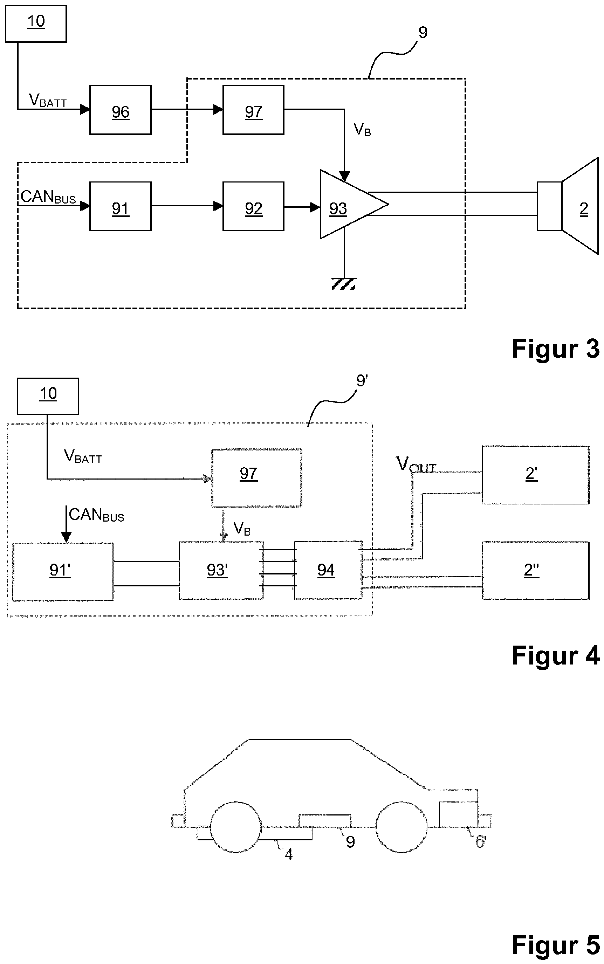

Die allgemeine Funktionsweise des vorstehenden Systems 7 ist wie folgt:
Anhand von durch die Fehlermikrofone 5, 5a jeweils gemessenem Schall und von über den CAN-Bus empfangenen Betriebsparametern des Verbrennungsmotors 6 berechnet ein in Figur 3 gezeigter Mikroprozessor 91, 91' der Antischall-Steuerung 9 unter Verwendung eines *Filtered-x Least mean squares* (FxLMS) Algorithmus für jeden Lautsprecher 2, 2a ein digitales Steuersignal, welches eine weitgehende Auslöschung des im Inneren der Ansauganlage 12 bzw. Abgasanlage geführten Schalls durch Beaufschlagung mit Anti-Schall erlaubt, und gibt dieses an den jeweiligen Lautsprecher 2, 2a aus.

In der Figur 3 ist eine erste Ausführungsform einer (Antischall-)Steuerung gezeigt, die in den Antischall-Systemen, die in den Figuren 1 und 2 gezeigt sind, verwendet wird. In der Figur 3 ist der besseren Übersichtlichkeit wegen nur der Teil gezeigt, der den der Abgasanlage zugeordneten Lautsprecher 2 betrifft.

Gemäß der in Figur 3 gezeigten ersten Ausführungsform weist die Steuerung 9 neben dem Mikroprozessor 91 einen Digital/Analog-Umsetzer 92 auf, der mit dem Mikroprozessor 91 verbunden ist und das von dem Mikroprozessor 91 ausgegebene digitale Steuersignal in ein analoges Steuersignal umsetzt und an einen Klasse-A-Verstärker 93 ausgibt. Der Klasse-A-Verstärker 93 hebt das vom Digital/Analog-Umsetzer 92 empfangene analoge Steuersignal auf ein Niveau an, welches einen Betrieb des Lautsprechers 2 erlaubt, und gibt das verstärkte analoge Steuersignal an den Lautsprecher 2 aus. Es wird betont, dass zwischen dem Klasse-A-Verstärker 93 und dem Lautsprecher 2 optional ein Filter angeordnet ist. Weiter können andere Arten von analogen Verstärkern und insbesondere Audioverstärkern verwendet werden.

Die Versorgungsspannung V_{B} des Klasse-A-Verstärkers 93 wird diesem von einem Aufwärtsregler 97 bereitgestellt, der über einen Filter 96 von einer Fahrzeugbatterie 10 mit Batteriespannung V_{BATT} versorgt wird. In der vorliegenden Ausführungsform setzt der Aufwärtsregler 97 die ihm zugeführte Batteriespannung V_{BATT}, welche zwischen 9 V und 16 V schwankt, in von dieser schwankenden Eingangsspannung unabhängige Versorgungsspannung V_{B} für den Klasse-A-Verstärker 93 von konstanten 24 V um. In der Folge ist auch das von dem Klasse-A-Verstärker 93 an den Lautsprecher 2 ausgegebene verstärkte analoge Steuersignal hinsichtlich seines Pegels von der schwankenden Batteriespannung unabhängig. Dies ist wichtig, wenn bei der gezeigten Verwendung der Steuerung in einem Antischall-System ein Schallpegel des von der Abgasanlage 4 ausgegebenen Schalls aufgrund gesetzlicher Vorschriften in keinem Betriebszustand überschritten werden darf.

Weiter ist der Klasse-A-Verstärker 93 aufgrund seiner gegenüber der Batteriespannung V_{BATT} erhöhten Versorgungsspannung V_{B} in der Lage, an den Lautsprecher 2 ein verstärktes analoges Steuersignal mit gegenüber herkömmlichen Steuerungen erhöhtem Spannungsniveau auszugeben. Dies erlaubt zum einen die Verwendung eines hochohmigen Lautsprechers 2 mit gegenüber herkömmlichen Antischall-Systemen erhöhter Eingangsimpedanz, zum anderen werden aufgrund des höheren Spannungsniveaus Leitungsverluste in der Zuleitung zum Lautsprecher 2 verringert. Zudem führen die damit verbundenen niedrigeren Ströme auf den Zuleitungen zum Lautsprecher 2 zu niedrigeren elektromagnetischen Störungen, so dass die elektromagnetische Verträglichkeit (EMV) des Antischall-Systems 7 insgesamt verbessert ist. Schließlich erlaubt die gegenüber herkömmlichen Antischall-Steuerungen erhöhte Versorgungsspannung V_{B} des Klasse-A-Verstärker 93 die Realisierung eines höheren Scheitelfaktors, und damit die Realisierung eines größeren Verhältnisses von Scheitelwert zu Effektivwert des an den Lautsprecher 2 ausgegebenen verstärkten analogen Steuersignals. Ursächlich hierfür sind aufgrund der höheren Betriebsspannung realisierbare Leistungsreserven.

Die in Figur 4 gezeigte zweite Ausführungsform ist der vorstehend unter Verweis auf Figur 3 beschriebenen ersten Ausführungsform sehr ähnlich, so dass im Folgenden nur auf Unterschiede eingegangen und ansonsten auf die erste Ausführungsform verwiesen wird.

Anders als in der vorstehenden ersten Ausführungsform wird die Steuerung 9' gemäß der in Figur 4 gezeigten zweiten Ausführungsform nicht in einem Antischall-System verwendet, sondern zum Erzeugen von Schall mittels eines mit der Steuerung verbundenen, im Motorraum 6' eines Fahrzeugs angeordneten Lautsprechers.

Die zweite Ausführungsform unterscheidet sich von der ersten Ausführungsform weiter dadurch, dass der Mikroprozessor 91' einen integrierten Digital/Analog-Umsetzer aufweist, so dass auf einen separaten Digital/Analog-Umsetzer zwischen Mikroprozessor 91' und dem Verstärker 93' verzichtet werden kann. Zudem wird als Verstärker ein Klasse-D-Verstärker 93' verwendet.

Weiter ist gemäß der zweiten Ausführungsform der Aufwärtsregler 97 direkt mit der Fahrzeugbatterie 10 verbunden, so dass zwischen Fahrzeugbatterie und Aufwärtsregler 97 kein Filter vorgesehen ist.

Weiter ist gemäß der zweiten Ausführungsform am Ausgang des Klasse-D-Verstärkers 93' ein LC-Tiefpass 94 angeordnet, in welchen LC-Tiefpass 94 ein Modul zur Verbesserung der elektromagnetischen Verträglichkeit integriert ist.

Schließlich sind gemäß der zweiten Ausführungsform zwei im Motorraum 6' des Fahrzeugs angeordnete Lautsprecher 2', 2'' vorgesehen, welche über den LC-Tiefpass 94 von dem Klasse-D-Verstärker 93' mit dem verstärkten analogen Steuersignal versorgt werden. Entsprechend ist der Mikroprozessor 91' ausgebildet, ein digitales Steuersignal zu erzeugen, welches geeignet ist, im Inneren eines Motorraumes 6' ein Motorgeräusch zu erzeugen, wenn die beiden Lautsprecher 2', 2" mit dem Steuersignal betrieben werden.

In der Figur 5 ist schematisch ein Kraftfahrzeug mit einem Motorraum 6', welcher den Verbrennungsmotor 6 aufnimmt, einer Abgasanlage 4 und der vorstehend beschriebenen Steuerung 9, 9' gezeigt. Der Schallerzeuger und der Lautsprecher des Systems sind in Figur 5 nicht eigens gezeigt. Wenn das Fahrzeug über einen vom Motorraum 6' aufgenommenen Elektromotor verfügt, kann auf die Abgasanlage 4 verzichtet werden.

In den Figuren sind im Interesse einer übersichtlichen Darstellung nur diejenigen Elemente, Komponenten und Funktionen dargestellt, die einem Verständnis der vorliegenden Erfindung förderlich sind. Ausführungsformen der Erfindung sind jedoch nicht auf die dargestellten Elemente, Komponenten und Funktionen beschränkt, sondern enthalten weitere Elemente, Komponenten und Funktionen, soweit sie für ihre Verwendung oder ihren Funktionsumfang erforderlich sind.

Auch wenn die Erfindung vorstehend anhand von maximal zwei Lautsprechern und entsprechend maximal zwei Abgasanlagen beschrieben wurde, ist die vorliegende Erfindung hierauf nicht begrenzt. Vielmehr lässt sich die Erfindung auf eine beliebige Anzahl von Lautsprechern und Abgasanlagen erweitern. Auch wenn die vorliegende Erfindung anhand von Antischall-Systemen beschrieben wurde, die sowohl der Abgasanlage als auch in der Ansauganlage zugeordnet sind, ist die vorliegende Erfindung hierauf nicht beschränkt. So kann auf eines dieser Antischall-Systeme oder auch beide verzichtet werden.

Auch wenn vorstehend die erste Ausführungsform der Steuerung in Verbindung mit einem Antischall-System und die zweite Ausführungsform in Verbindung mit einem System zur Erzeugung von Motorgeräuschen in einem Motorraum beschrieben worden ist, so ist die Erfindung hierauf nicht beschränkt. Beispielsweise kann die Steuerung der zweiten Ausführungsform in einem Antischall-System und die Steuerung der ersten Ausführungsform in einem System zur Erzeugung von Motorgeräuschen in einem Motorraum verwendet werden. Weiter kann gleichzeitig wenigstens ein Antischall-System und ein System zur Erzeugung von Motorgeräuschen in einem Motorraum vorgesehen sein.

## Patentansprüche

1. System (7) zur Beeinflussung von Abgasgeräuschen und/oder Ansauggeräuschen und/oder Motorgeräuschen eines Fahrzeugs, aufweisend:
eine Steuerung (9); und
wenigstens einen Lautsprecher (2), welcher zum Empfang von Steuersignalen mit der Steuerung (9) verbunden ist, wobei der wenigstens eine Lautsprecher (2) in Abhängigkeit eines von der Steuerung (9) empfangenen Steuersignals zum Erzeugen eines Schalls in einem zugehörigen Schallerzeuger (3) ausgebildet ist;
wobei die Steuerung (9) aufweist:
wenigstens einen Mikroprozessor (91; 91'), der ausgebildet ist, ein digitales Steuersignal zu erzeugen, welches geeignet ist, Schall im Inneren einer Ansauganlage (12) und/oder Abgasanlage (4) des Fahrzeugs zumindest teilweise und bevorzugt vollständig auszulöschen, und/oder welches digitale Steuersignal geeignet ist, im Inneren eines Motorraumes ein Geräusch und insbesondere ein Motorgeräusch zu erzeugen;
wenigstens einen Digital/Analog-Umsetzer (92), welcher mit dem wenigstens einen Mikroprozessor (91; 91') verbunden und ausgebildet ist, das von dem wenigstens einen Mikroprozessor (91; 91') ausgegebene digitale Steuersignal in ein analoges Steuersignal umzuwandeln; und
wenigstens einen Verstärker (93), welcher mit dem wenigstens einen Digital/Analog-Umsetzer (92) verbunden und ausgebildet ist, das von dem wenigstens einen Digital/Analog-Umsetzer (92) ausgegebene analoge Steuersignal zu verstärken;
**gekennzeichnet durch**
einen Aufwärtsregler (97), welcher mit einer Fahrzeugbatterie (10) des Fahrzeugs verbindbar und ausgebildet ist, eine von der Fahrzeugbatterie (10) gelieferte Batteriespannung (VBATT) auf einen konstanten Wert heraufzusetzen und als Versorgungsspannung (VB) an den wenigstens einen Verstärker (93) auszugeben;
wobei der Aufwärtsregler (97) ausgebildet ist, die von der Fahrzeugbatterie (10) gelieferte Batteriespannung (VBATT) von einer zwischen 9 V und 16 V schwankenden Spannung auf 12 V oder 16 V heraufzusetzen und als Versorgungsspannung (VB) an den wenigstens einen Verstärker (93) auszugeben.

2. System (7) nach Anspruchs 1,
wobei die Steuerung (9) mit einer Motorsteuerung (11) eines Antriebsmotors (6) des Fahrzeugs verbindbar ist; und
wobei der wenigstens eine Mikroprozessor (91; 91') der Steuerung (9) ausgebildet ist, das digitale Steuersignal in Abhängigkeit von Signalen zu erzeugen, welche von der Motorsteuerung (11) empfangen werden.

3. System (7) nach einem der Ansprüche 1 oder 2,
wobei der Schallerzeuger (3) mit der Ansauganlage (12) und/oder Abgasanlage (4) in fluide Anbindung gebracht werden kann; und
das System weiter ein Fehlermikrofon (5) aufweist, welches mit der Steuerung (9) verbunden und an einer bezüglich der Strömung der angesaugten Luft im Bereich der fluiden Anbindung zwischen Schallerzeuger (3) und Ansauganlage (12) gelegenen Stelle der Ansauganlage (12) anordenbar ist; und/oder
das System weiter ein Fehlermikrofon (5) aufweist, welches mit der Steuerung (9) verbunden und an einer bezüglich der Abgasströmung im Bereich der fluiden Anbindung zwischen Schallerzeuger (3) und Abgasanlage (4) gelegenen Stelle der Abgasanlage (4) anordenbar ist;
wobei das Fehlermikrofon (5) ausgebildet ist, Schall im Inneren der Ansauganlage (12) und/oder Abgasanlage (4) zu messen und ein entsprechendes Messsignal an die Steuerung (9) auszugeben, und wobei der wenigstens eine Mikroprozessor (91; 91') der Steuerung (9) ausgebildet ist, von dem Fehlermikrofon (5) erhaltene Signale durch Ausgabe des Steuersignals an den wenigstens einen Lautsprecher (2) zumindest teilweise und bevorzugt vollständig auszulöschen.

4. System (7) nach einem der Ansprüche 1 bis 3, wobei der wenigstens eine Digital/Analog-Umsetzer (92) in den wenigstens einen Mikroprozessor (91') integriert ist.

5. System (7) nach einem der Ansprüche 1 bis 4, wobei zwischen der Fahrzeugbatterie (10) und dem Aufwärtsregler (97) ein Filter (96) und insbesondere ein Spannungsglätter angeordnet ist.

6. System (7) nach einem der Ansprüche 1 bis 5, wobei der wenigstens eine Lautsprecher (2) eine Eingangsimpedanz von zwischen 2 Ω und 12 Ω und insbesondere von zwischen 3 Ω und 4 Ω aufweist.

7. System (7) nach einem der Ansprüche 1 bis 6, wobei der wenigstens eine Verstärker (93) ein Klasse-D-Verstärker ist; und
wobei zwischen dem wenigstens einen Verstärker (93) und dem wenigstens einen Lautsprecher (2) ein LC-Tiefpass (94) angeordnet ist.

8. Kraftfahrzeug (12) aufweisend:
einen Verbrennungsmotor (6) mit einer Motorsteuerung (11);
eine Ansauganlage (12), die mit dem Verbrennungsmotor (6) in Fluidverbindung steht;
eine Abgasanlage (4), die mit dem Verbrennungsmotor (6) in Fluidverbindung steht;
eine Fahrzeugbatterie (10); und ein System (7) nach einem der Ansprüche 1 bis 7,
wobei der wenigstens eine Schallerzeuger (3) des Systems (7) mit der Ansauganlage (12) und/oder Abgasanlage (4) in fluider Anbindung steht; und wobei die Steuerung (9) des Systems (7) mit der Motorsteuerung (11) des Verbrennungsmotors (6) des Fahrzeugs verbunden ist.

9. Kraftfahrzeug (12) nach Anspruch 8,
wobei die Steuerung (9) ein Fehlermikrofon (5) aufweist, welches an einer bezüglich der Strömung der angesaugten Luft im Bereich der fluiden Anbindung zwischen Schallerzeuger (3) und Ansauganlage (12) gelegenen Stelle der Ansauganlage (12) angeordnet und mit der Ansauganlage (12) verbunden ist; und/oder
wobei die Steuerung (9) ein Fehlermikrofon (5) aufweist, welches an einer bezüglich der Abgasströmung im Bereich der fluiden Anbindung zwischen Schallerzeuger (3) und Abgasanlage (4) gelegenen Stelle der Abgasanlage (4) angeordnet und mit der Abgasanlage (4) verbunden ist; und
wobei die Steuerung (9) mit dem Fehlermikrofon (5) verbunden ist.

10. Kraftfahrzeug (12) aufweisend:
einen in einem Motorraum angeordneten Antriebsmotor (6) mit einer Motorsteuerung (11);
eine Fahrzeugbatterie (10); und
ein System (7) nach einem der Ansprüche 1 bis 7,
wobei der wenigstens eine Schallerzeuger (3) des Systems (7) mit dem Motorraum in fluider Anbindung steht oder in dem Motorraum angeordnet ist; und
wobei die Steuerung (9) des Antischall-Systems (7) mit der Motorsteuerung (11) des Antriebsmotors (6) des Fahrzeugs verbunden ist.

## Claims

1. A system (7) for influencing exhaust gas noises and/or intake noises and/or engine noises of a vehicle, comprising:
a controller (9); and
at least one loudspeaker (2) connected to the controller (9) for receiving control signals, with the at least one loudspeaker (2) configured for generating a noise inside a sound generator (3) in response to a control signal received from the controller (9);
wherein the controller (9) comprises:
at least one microprocessor (91; 91') configured for generating a digital control signal, with the digital control signal being adapted to cancel noise inside an intake system (12) and/or an exhaust system (4) of the vehicle at least partially or preferably completely in amplitude and phase, and/or with the digital control signal being adapted to generate a noise, and in particular an engine noise, inside an engine compartment;
at least one digital-to-analog converter (92) connected to the at least one microprocessor (91, 91') and being adapted to convert the digital control signal output from the at least one microprocessor (91, 91') into an analog control signal; and
at least one amplifier (93) connected to the at least one digital-to-analog converter (92) and being adapted to amplify the analog control signal output from the at least one digital-to-analog converter (92);
**characterized by**
a step-up converter (97) configured for being connected to an automobile battery (10) of the vehicle and being adapted to up-convert a battery voltage (VBATT) supplied by the automobile battery (10) to a higher, constant value, and to output the same as supply voltage (VB) to the at least one amplifier (93);
wherein the step-up converter (97) is configured to up-convert the battery voltage (VBATT) supplied from the automobile battery (10) from a voltage varying between 9 V and 16 V to a constant value of 12 V or 16 V, and to output it as supply voltage (VB) to the at least one amplifier (93).

2. The system (7) according to claim 1,
wherein the controller (9) is configured for being connected with an engine control unit (11) of a driving engine (6) of the vehicle; and
wherein the at least one microprocessor (91, 91') of the controller (9) is configured to generate the digital control signal in response to signals received by the engine control unit (11).

3. The system (7) according to one of claims 1 or 2,
wherein the sound generator (3) is configured for being connected with the intake system (12) and/or the exhaust system (4) in a fluid communication; and
the system further comprises an error microphone (5) connected to the controller (9) and being configured for being disposed at a position of the intake system (12) located in the region of the, with respect to the flow of drawn in air, fluid connection between the sound generator (3) and the intake system (12); and/or the system further comprises an error microphone (5) connected to the controller (9) and being configured for being disposed at a position of the exhaust system (4) located in the region of the, with respect to the exhaust gas flow, fluid connection between the sound generator (3) and the exhaust system (4);
wherein the error microphone (5) is configured to measure noise inside the intake system (12) and/or the exhaust system (4), and to output a corresponding measurement signal to the controller (9), and wherein the at least one microprocessor (91, 91') of the controller (9) is configured to at least partially and preferably completely cancel signals received from the error microphone (5) by outputting the control signal to the at least one loudspeaker (2).

4. The system (7) according to one of claims 1 to 3, wherein the at least one digital-to-analog converter (92) is integrated into the at least one microprocessor (91').

5. The system (7) according to one of claims 1 to 4, wherein a filter (96), and in particular a voltage smoothing circuit, is disposed between the automobile battery (10) and the step-up converter (97).

6. The system (7) according to one of claims 1 to 5, wherein the at least one loudspeaker (2) has an input impedance of between 2 Ω and 12 Ω, and in particular of between 3 Ω und 4 Ω.

7. The system (7) according to one of claims 1 to 6,
wherein the at least one amplifier (93) is a class D amplifier; and
wherein a LC low pass (94) is disposed between the at least one amplifier (93) and the at least one loudspeaker (2).

8. A motor vehicle (12) comprising:
an internal combustion engine (6) having an engine control unit (11);
an intake system (12) in fluid communication with the internal combustion engine (6);
an exhaust system (4) in fluid communication with the internal combustion engine (6);
an automobile battery (10); and
a system (7) according to one of claims 1 to 7;
wherein the at least one sound generator (3) of the system (7) is in fluid communication with the intake system (12) and/or the exhaust system (4); and
wherein the controller (9) of the system (7) is connected to the engine control unit (11) of the internal combustion engine (6) of the vehicle.

9. The motor vehicle (12) according to claim 8,
wherein the controller (9) comprises an error microphone (5) disposed at a position of the intake system (12) located with respect to the flow of the drawn in air in a region of the fluid connection between the sound generator (3) and the intake system (12) and being connected to the intake system (12); and/or wherein the controller (9) comprises an error microphone (5) disposed at a position of the exhaust system (4) located with respect to the flow of the exhaust gases in a region of the fluid connection between the sound generator (3) and the exhaust system (4) and being connected to the exhaust system (4); and wherein the controller (9) is connected to the error microphone (5).

10. A motor vehicle (12) comprising:
a driving engine (6) disposed in an engine compartment with an engine control unit (11);
an automobile battery (10); and
a system (7) according to one of claims 1 to 7;
wherein the at least one sound generator (3) of the system (7) is in fluid communication with the engine compartment or disposed within the engine compartment; and
wherein the controller (9) of the anti-noise system (7) is connected to the engine control unit (11) of the driving engine (6) of the vehicle.

## Revendications

1. Système (7) servant à influencer des bruits d'échappement et/ou des bruits d'aspiration et/ou des bruits de moteur d'un véhicule, présentant :
une commande (9) ; et
au moins un haut-parleur (2), qui est relié à la commande (9) pour recevoir des signaux de commande, dans lequel le haut-parleur (2) est disposé pour générer un son dans un générateur de son (3) associé en fonction d'un signal de commande reçu de la commande (9), dans lequel la commande (9) présente :
au moins un microprocesseur (91 ; 91'), qui est disposé pour générer un signal de commande numérique, qui est adapté pour supprimer au moins en partie et de manière préférée en totalité le son à l'intérieur d'un système d'aspiration (12) et/ou d'un système d'échappement (4) du véhicule, et/ou lequel signal de commande numérique est adapté pour générer un bruit en particulier un bruit de moteur à l'intérieur d'un compartiment moteur ;
au moins un convertisseur numérique-analogique (92), qui est relié au microprocesseur (91 ; 91') et est disposé pour convertir le signal de commande numérique envoyé par le microprocesseur (91 ; 91') en un signal de commande analogique ; et
au moins un amplificateur (93), qui est relié au convertisseur numérique-analogique (92) et est disposé pour amplifier le signal de commande analogique envoyé par le convertisseur numérique-analogique (92) ;
**caractérisé par**
un régulateur-élévateur (97), qui peut être relié à une batterie de véhicule (10) du véhicule et est disposé pour augmenter une tension de batterie (VBATT) fournie par la batterie de véhicule (10) sur une valeur constante et l'envoyer en tant que tension d'alimentation (VB) à l'amplificateur (93) ;
dans lequel le régulateur-élévateur (97) est disposé pour augmenter la tension de batterie (VBATT) fournie par la batterie de véhicule (10) depuis une tension fluctuant entre 9 V et 16 V vers 12 V ou 16 V et l'envoyer en tant que tension d'alimentation (VB) à l'amplificateur (93).

2. Système (7) selon la revendication 1,
dans lequel la commande (9) peut être reliée à une commande moteur (11) d'un moteur d'entraînement (6) du véhicule ; et
dans lequel le microprocesseur (91 ; 91') de la commande (9) est disposé pour générer le signal de commande numérique en fonction des signaux, qui sont reçus par la commande de moteur (11).

3. Système (7) selon l'une des revendications 1 ou 2,
dans lequel le générateur de son (3) peut être amené en communication fluidique avec le système d'aspiration (12) et/ou le système d'échappement (4) ; et
le système présente en outre un microphone d'erreur (5), qui est relié à la commande (9) et peut être agencé sur un emplacement du système d'aspiration (12) placée par rapport à l'écoulement de l'air aspiré dans la zone de la communication fluidique entre le générateur de son (3) et le système d'aspiration (12) ; et/ou
le système présente en outre un microphone d'erreur (5), qui est relié à la commande (9) et peut être agencé sur un emplacement du système d'échappement (4) placé par rapport à l'écoulement de gaz d'échappement dans la zone de la communication fluidique entre le générateur de son (3) et le système d'échappement (4) ;
dans lequel le microphone d'erreur (5) est disposé pour mesurer un son à l'intérieur du système d'aspiration (12) et/ou du système d'échappement (4) et pour envoyer à la commande (9) un signal de mesure correspondant, et dans lequel le microprocesseur (91 ; 91') de la commande (9) est agencé pour supprimer au moins en partie et de manière préférée en totalité des signaux reçus par le microphone d'erreur (5) par l'envoi du signal de commande au haut-parleur (2).

4. Système (7) selon l'une des revendications 1 à 3, dans lequel le convertisseur numérique-analogique (92) est intégré dans le microprocesseur (91').

5. Système (7) selon l'une des revendications 1 à 4, dans lequel un filtre (96), en particulier un système de lissage de tension, est agencé entre la batterie de véhicule (10) et le régulateur-élévateur (97).

6. Système (7) selon l'une des revendications 1 à 5, dans lequel le haut-parleur (2) présente une impédance d'entrée comprise entre 2 Ω et 12 Ω et en particulier comprise entre 3 Ω et 4 Ω.

7. Système (7) selon l'une des revendications 1 à 6, dans lequel l'amplificateur (93) est un amplificateur de classe D ; et
dans lequel un filtre LC passe-bas (94) est agencé entre l'amplificateur (93) et le haut-parleur (2).

8. Véhicule automobile (12) présentant :
un moteur à combustion interne (6) avec une commande de moteur (11) ;
un système d'aspiration (12), qui est en communication fluidique avec le moteur à combustion interne (6) ;
un système d'échappement (4), qui est en communication fluidique avec le moteur à combustion interne (6) ;
une batterie de véhicule (10) ; et
un système (7) selon l'une des revendications 1 à 7,
dans lequel le générateur de son (3) du système (7) est en communication fluidique avec le système d'aspiration (12) et/ou le système d'échappement (4) ; et
dans lequel la commande (9) du système (7) est reliée à la commande de moteur (11) du moteur à combustion interne (6) du véhicule.

9. Véhicule automobile (12) selon la revendication 8,
dans lequel la commande (9) présente un microphone d'erreur (5), qui est agencé sur un emplacement du système d'aspiration (12) placé par rapport à l'écoulement de l'air aspiré dans la zone de la communication fluidique entre le générateur de son (3) et le système d'aspiration (12) et est relié au système d'aspiration (12) ; et/ou
dans lequel la commande (9) présente un microphone d'erreur (5), qui est agencé sur un emplacement du système d'échappement (4) placé par rapport à l'écoulement de gaz d'échappement dans la zone de la communication fluidique entre le générateur de son (3) et le système d'échappement (4) et est relié au système d'échappement (4) ; et
dans lequel la commande (9) est reliée au microphone d'erreur (5).

10. Véhicule automobile (12) présentant :
un moteur d'entraînement (6) agencé dans un compartiment moteur avec une commande de moteur (11) ;
une batterie de véhicule (10) ; et
un système (7) selon l'une des revendications 1 à 7,
dans lequel le générateur de son (3) du système (7) est en communication fluidique avec le compartiment moteur ou est agencé dans le compartiment moteur ;
et
dans lequel la commande (9) du système anti-son (7) est reliée à la commande de moteur (11) du moteur d'entraînement (6) du véhicule.
